# EUROPEAN PATENT APPLICATION

(11) **EP 1 382 974 A1**
(43) Date of publication of application: **21.01.2004**
(21) Application number: 02291833.8
(22) Date of filing: 19.07.2002
(51) Int. Cl.: G01R 31/28, H04N 5/00

(54) **Method and smart card for testing an appliance having a smart card reader, and a respective appliance**

(71) Applicant: Thomson Licensing S.A., 92648 Boulogne Cedex (FR)
(72) Inventor: Languedoc, Thierry, 78610 Le Perray en Yvelines (FR); Faye, Daniel, 78250 Meulan (FR)
(74) Representative: Rittner, Karsten, Dr.

(57) **Abstract**

For testing of an appliance (1) having a smart card reader (4), a smart card (2) is used as a test tool, which is inserted into the a smart card reader (4) for the testing. The smart card (2) comprises digital data for a test procedure of the appliance or at least data for starting a test procedure of the appliance. The test procedure itself may be stored in a memory of the smart card (2) or in a memory of the set-top box (1). Respective test procedures are for example a Factory Functional Test or an after sales diagnostics test for the appliance. The method and the smart card are used in particular for testing a digital set-top box or a digital satellite receiver.

## Description

### Background

The invention relates to a method for testing an appliance having a smart card reader for operation with a smart card, and a respective appliance. Appliances of this kind are known for example from pay television broadcast (Pay TV), electronic payment, or banking services.

Smart cards, also known as IC cards, are portable information media, having the size of about a credit card. They comprise an integrated card controller, or at least an integrated memory, for a data exchange with a respective appliance. A portable device of this kind is known for example from EP-A-0 633 544. As a general term for this data media the expression "smart card" will be used throughout in this description. Usually, smart cards are provided with contacts being mechanically contacted by a smart card reader for an electrical connection for a data exchange with the respective appliance, but smart cards with wireless contact means, having no direct mechanical contact connection, are known also.

The communication between smart cards and respective appliances is described for example in WO 97/25685 and EP-A-0 814 427. An international standard, which describes and defines smart cards having contacts and the operation procedures of smart cards, is ISO/IEC 7816-3:1997(E). This standard is used particularly for pay television systems, which use a set-top box or a digital satellite receiver with a smart card reader and smart cards for authorizing the reception of pay television broadcasts. The respective smart cards comprise data, which enable the set-top box to unscramble received coded video signals.

It is known to provide a digital set-top box with a so-called FFT interface for allowing Factory Functional Tests (FFT). This is a tool, which gives the capability to drive the set-top box hardware through its low level drivers, by using an external computer, for example a PC. The computer is coupled via a standard EIA-RS232 communication port to the set-top box, the set-top box comprising a respective port for example at the rear side. This test method uses a FFT commands library, which is common to all the respective appliances. The main idea of this tool is to provide easy access during the factory process, especially for the consumer test after production of the appliance, when the box is closed. This feature is also very useful for after-sales diagnostics or development diagnostics too.

It is an object of the invention to provide a method for testing an appliance having a smart card reader for operation with a smart card, which allows to reduce the costs for the appliance, and to provide a respective appliance.

### Invention

This object is achieved for a method as specified in claim 1. A respective smart card is specified in claim 5 and a respective appliance in claim 8. Advantageous developments of the invention are specified in the subclaims.

According to the invention, a smart card is used as a test tool, which is inserted into the smart card reader of the appliance for testing of the appliance. The smart card comprises digital data for a test procedure of the appliance or at least data for starting a test procedure of the appliance. The test procedure itself may be stored in a memory of the smart card or in a memory of the set-top box.

The respective smart card comprises a card controller with a memory, in which data are stored for performing a test procedure, or at least data for starting a test procedure for the appliance.

The method and the smart card for testing of the appliance may be used in particularly for testing a digital set-top box or a digital satellite receiver. Respective test programs are for example a Factory Functional Test (FFT) or an after sales diagnostics test of the appliance. With this method, the often used RS232 connector and the respective interface in a set-top box is no more necessary. No additional hardware inside the set-top box is required. Only a few modifications of the software of the set-top box are necessary.

In the case of a digital set-top box or a digital satellite receiver, a television set being connected with the appliance is used advantageously for displaying the test results. Then the already available On-Screen-Display circuit (OSD) within the appliance can be used for displaying of the test data on the television set. As such, the debug port is redirected to the On-Screen-Display circuit to display the test results on the display of the television set. As an alternative, the appliance may comprise a display, on which the results of the test program are displayed. The appliance can be also a television set, having a digital receiver with a smart card reader.

The smart card for testing of the appliance comprises a card controller and a memory, in which a test program is stored. As an alternative, the test program is stored in the appliance, and the smart card comprises data, which initialises the appliance for testing and which calls up the respective test program already stored in a memory of the appliance. The smart card may be protected also with a security code, which allows only authorised persons to perform the tests. Also, several levels of access rights might be installed.

The respective appliance for operating with a smart card, which comprises data for a test of the appliance, has a memory, in which data are stored for recognizing the respective smart card. After insertion of a smart card, the appliance provides in a first step a smart card activation with a reset, and in a further step, when the answer to the activation of the smart card is negative, the appliance provides a test mode initialisation for a test procedure in cooperation with a respective smart card for testing of the appliance. In the next step, the smart card transmits data to the appliance, which starts a respective test program. The test program may be stored in a memory of the smart card or in a memory of the appliance. It may be stored also in some part in a memory of the smart card and in a memory of the appliance. The appliance therefore does no more need the serial RS232 interface with the respective connector. This leads to a considerable cost reduction of the appliance.

### Drawings

Preferred embodiments of the invention are now explained in more detail with reference to schematic drawings, which show:
- Fig. 1: an appliance with a smart card for testing of the appliance, and
- Fig. 2: a flow chart showing the method steps for testing of a digital set-top box.

### Preferred Embodiments

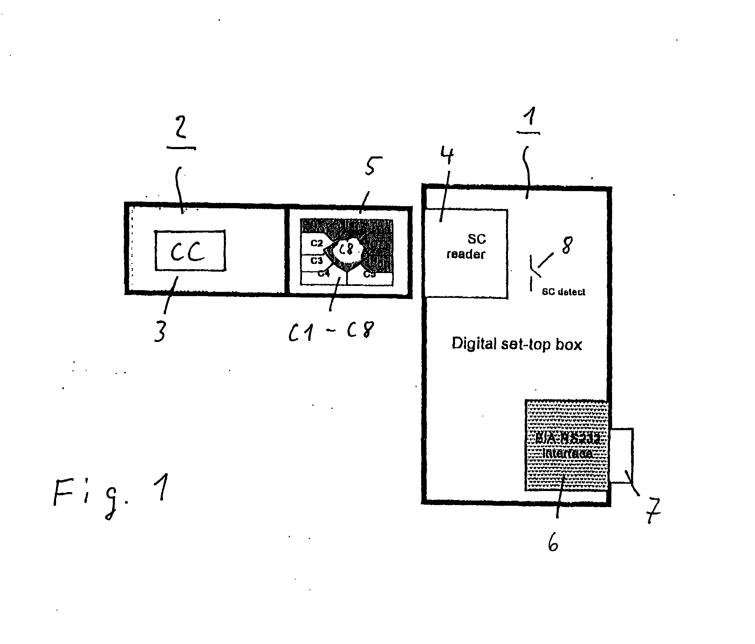

In fig. 1 a system is shown for testing of the appliance 1, in this embodiment a digital set-top box 1, the system comprising a smart card 2, which is inserted into a smart card reader 4 of the digital set-top box 1 for testing purposes. The smart card 2 comprises a card controller 3 with a memory, which comprises data for performing respective tests of the set-top box. The test is in particular a factory functional test (FFT) of the set-top box 1, or an after sales diagnostics test.

The smart card reader 4 complies in this embodiment with the ISO/IEC 7816/3 standard. The smart card 2 comprises respective contacts C1 - C8 for a data exchange according to this standard.

When the smart card 2 is inserted into the smart card reader 4, a card switch 8 is actuated and the set-top box 1 recognises, that a smart card has been inserted. The set-top box 1 provides then in a first step a reset signal for the smart card controller 3, for initialising the smart card 2 for an operation of the set-top box 1, for example to unscramble coded video signals for a display of a respective television program on a television set.

When the answer to the reset signal from the smart card 2 is negative, the set-top box 1 assumes then, that a smart card 2 for testing of the set-top box 1 has been inserted. The set-top box 1 goes then in an operating mode for a testing of the set-top box 1.

The results of a respective test are displayed on a television set (not shown) being connected with the set-top box 1. In case of a set-top box or digital satellite receiver, the display on respective television set is preferred because in this case the already available On-Screen display circuit of the set-top box or the satellite receiver can be used. The appliance 1 then does not need any further hardware components, for performing the tests. As an alternative, the test result might be displayed on a display of appliance 1.

The EIA-RS232 interface 6 and the respective sub-D connector 7 at the rear side of the set-top box 1, which has been used before for testing of the set-top box 1, is therefore no more necessary, when using the smart card 2. This leads to a cost reduction of the set-top box 1 of about 0,5 Euro. The costs of the smart card 2 with the test data are negligible because only a few smart cards are necessary for testing of a complete production series in the factory, for example for performing the factory functional tests.

The new method allows therefore an easy testing of all respective set-top boxes, because a smart card reader 4 is always implemented, even in low-end set-top boxes. There is only a minor disadvantage, that service personal outside of the factory has no excess for testing of the set-top box 1, when they don't have the respective smart card 2.

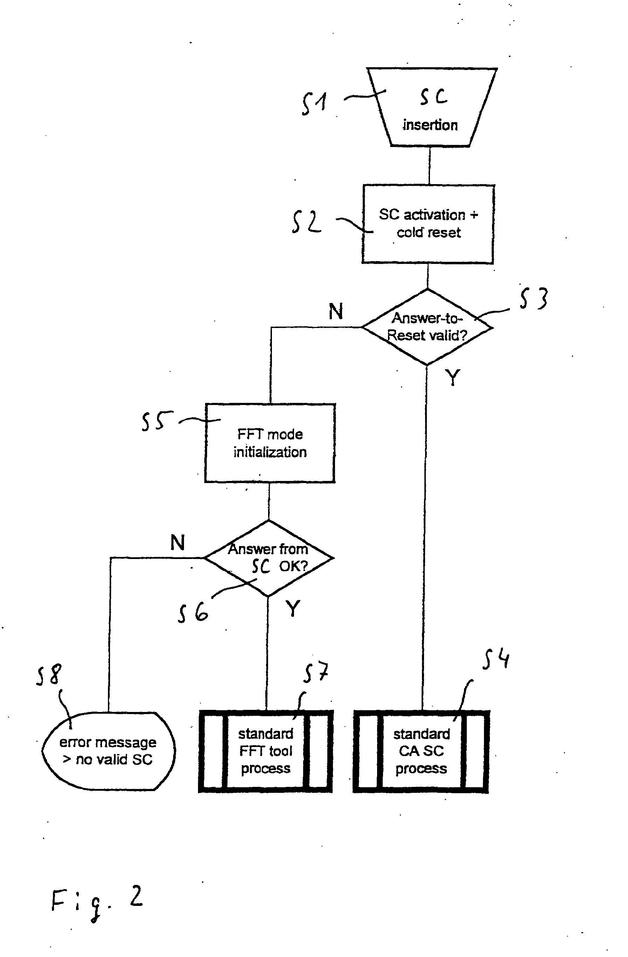

The steps of the new method are now described in more detail with reference to a flow chart as shown in Fig. 2. In step S1, a smart card 2 is inserted into the smart card reader 4 of the set-top box 1 and the card switch 8 is actuated. The controller of the set-top box 1 assumes then, that a smart card has been inserted into the smart card reader 4 for a normal operation of the set-top box 1, for example to descramble television signals for displaying a television program on a respective television set. In step S2, the set-top box 1 provides then a reset signal for a cold reset, to provide an activation of the assumed smart card.

In step S3, the set-top box 1 waits for an answer to the reset signal of step S2. When a valid smart card has been inserted into the smart card reader 4, the answer to the reset is positive (Y), and then a normal operation with the smart card is starting, step S4, for example the reception and descrambling of a television broadcast, as wanted by a user of the set-top box 1.

Is the answer to the reset signal of step S2 negative (N), then the set-top box 1 begins with the initialisation for a test procedure, step S5, for example a factory functional test (FFT). The set-top box 1 assumes then that a respective smart card has been inserted. In the next step, step S6, the set-top box 1 waits for a positive signal from the smart card 2 for performing tests. Then the tests are performed, step S7. The test program may be stored in a memory of the set-top box 1, which is then started after a positive signal from the smart card 2, after step S6. As an alternative, the test program may be stored in the smart card 2, which is transferred then to the set-top box 1 in step S7 for performing the tests. Nowadays already smart cards having a memory of 1 MB are known, which are therefore able to store also larger test programs.

When the set-top box 1 does not receive a positive signal (Y) for performing a test in step S6, the set-top box 1 displays an error message on its display: "No valid smart card", step S8. Then no valid smart card for an operation of the set-top box 1 has been inserted into the smart card reader 4.

The embodiments as described with regard to Fig. 1 and 2 comply with the specification according to ISO/IEC 7816/3, but other applications lie also within the range of the invention. A smart card 2 with a wireless transmission of data may be used also with a respective appliance, therefore not requiring a mechanical contacting. Several kinds of smart cards with wireless contacts are already known from prior art.

## Claims

1. Method for testing an appliance (1) having a smart card reader (4) for operation with a smart card, **characterised in that** a smart card (2) comprising data for initialising a test procedure of the appliance (1) is used.

2. Method according to claim 1, **characterised in that** the appliance (1) is a digital set-top box, a digital satellite receiver or a television set comprising a digital receiver, and that said test procedure is a factory functional test or an after sales diagnostics test.

3. Method according to claim 1 or 2, **characterised in that** the results of said test procedure are displayed on a television set being connected to the appliance (1) by using an On-Screen-Display circuit of the appliance (1) .

4. Method according to claim 1, 2 or 3, **characterised in that** said smart card (2) comprises a micro-controller (3) with a memory, in which data for performing a test procedure of the appliance (1) are stored.

5. Smart card comprising a micro-controller and a memory, **characterised in that** the memory comprises data for a method for testing an appliance (1) according to one of the preceding claims.

6. Smart card according to claim 5, **characterised in that** said smart card is protected by a security code.

7. Smart card according to claim 5 or 6, **characterised in that** said test data are stored with a smart card reader in a flash memory of the smart card (2).

8. Appliance with a smart card reader (4) for operation with a smart card, **characterised in that** the appliance (1), after insertion of a smart card, provides a smart card activation (S2), and in a further step, when the answer to the activation of the smart card is negative (S3), the appliance (1) provides a test mode initialisation (S5) for a method for testing an appliance (1) according to one of the claims 1 to 4.

9. Appliance according to claim 8, **characterised in that** results of the test program are displayed on a television set, being connected with the appliance (1), by an On-Screen-Display circuit of the appliance.

10. Appliance according to claim 8 or 9, **characterised in that** the appliance (1) comprises a memory with a program for testing of the appliance (1), which is started when a smart card according to claim 5 or 6 is inserted.

11. Appliance according to claim 8, 9 or 10, **characterised in that** the appliance (1) is a digital set-top box, a digital satellite receiver or a television set comprising a digital receiver, and that the method for testing of the appliance is a Factory Functional Test or an after sales diagnostics test.

12. Appliance (1) with:
- a decoder for converting a video digital stream into analog video signals ;
- an OSD generator generating OSD signals for superimposition on said analog video signals ;
- a microprocessor executing software instructions ;
- means sending a representation of said instructions to the OSD generator.
